(19) Europäisches Patentamt
European Patent Office
Office européen des brevets

(11) **EP 4 314 958 B1**

(12) # EUROPEAN PATENT SPECIFICATION

(45) Date of publication and mention
of the grant of the patent:
**22.10.2025   Bulletin 2025/43**

(21) Application number: **21716314.6**

(22) Date of filing: **29.03.2021**

(51) International Patent Classification (IPC):
*H04L 67/12* (2022.01)     *G06N 3/006* (2023.01)
*G06N 3/08* (2023.01)     *G05B 13/02* (2006.01)
*H04L 67/561* (2022.01)

(52) Cooperative Patent Classification (CPC):
**H04L 67/12; G05B 13/027; G06N 3/006;
G06N 3/0499; G06N 3/08; G06N 3/09; G06N 3/092;
H04L 67/561**

(86) International application number:
**PCT/EP2021/058180**

(87) International publication number:
**WO 2022/207070 (06.10.2022 Gazette 2022/40)**

(54) **CATEGORISATION OF RESOURCES USING LIGHTWEIGHT MACHINE-TO MACHINE
PROTOCOL**

KATEGORISIERUNG VON RESSOURCEN UNTER VERWENDUNG EINES LEICHTGEWICHTIGEN
MASCHINE-ZU-MASCHINE-PROTOKOLLS

CATÉGORISATION DE RESSOURCES AU MOYEN D'UN PROTOCOLE DE MACHINE À MACHINE
LÉGER

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.02.2024   Bulletin 2024/06**

(73) Proprietor: **Telefonaktiebolaget LM Ericsson
(publ)
164 83 Stockholm (SE)**

(72) Inventors:
• **OCAK, Mert
02700 Kauniainen (FI)**
• **LAZRAQ, Tawfik
18146 Lidingö (SE)**
• **VALL-LLOSERA, Gemma
175 48 JÄRFÄLLA (SE)**

(74) Representative: **Ericsson
Patent Development
Torshamnsgatan 21-23
164 80 Stockholm (SE)**

(56) References cited:
**US-A1- 2021 049 460     US-B2- 10 212 261**

• **"Methods and Applications for Modeling and
Simulation of Complex Systems : 18th Asia
Simulation Conference, AsiaSim 2018, Kyoto,
Japan, October 27-29, 2018, Proceedings", vol.
946, 21 August 2018, SPRINGER SINGAPORE,
Singapore, ISBN: 978-981-1328-53-4, ISSN:
1865-0929, article MORIYAMA TAKAO ET AL:
"Reinforcement Learning Testbed for Power-
Consumption Optimization", pages: 45 - 59,
XP055866750, DOI: 10.1007/978-981-13-2853-4_4**

**Description**

TECHNICAL FIELD

Embodiments described herein relate to methods and apparatus for implementing Lightweight Machine-to-Machine (LwM2M) protocol, in particular for implementing LwM2M for use with artificial intelligence or machine learning systems.

BACKGROUND

The communication networks involving use of sensor devices collecting and transmitting various kinds of data are becoming more common. The networks of physical objects-"things"-that are embedded with sensors, software, and other technologies for the purpose of connecting and exchanging vast amounts of data with other devices and systems over the Internet are described as Internet of Things (IoT). Within IoT, limited processing power is a key attribute of IoT devices as their purpose is to supply data about physical objects while remaining autonomous. Heavy processing requirements use more battery power harming the IoT devices' ability to operate.

With the development and progressive scaling of IoT, the number of IoT sensors and amount of data they exchange increases greatly, which demands more resources, such as human, computing power and networking to effectively process such data.

In order to address a growing number IoT devices in an IoT ecosystem, where the IoT devices often come from different vendors, Open Mobile Alliance (OMA) Lightweight Machine-to-Machine (LwM2M) protocol has been designed as a light and compact device management protocol. LwM2M is used for managing IoT devices and their resources and runs on top of Constrained Application Protocol (CoAP), which either uses User Datagram Protocol (UDP) or Short Message Service (SMS) bindings. Hence, LwM2M is compatible with any constrained device which supports CoAP protocol.

The vast amounts of data generated by large numbers of IoT sensors are often very difficult to process by humans. Such process takes time and is costly.

Solutions based on artificial intelligence (AI) are increasingly used to process large datasets in order to optimize processes and to improve the quality and performance of existing systems. One category of solutions based on AI is machine learning (ML), which, in a simplified form, involves processing the collected data that is fed to the model. The data may be used to train a model so that patterns and insights in the data may be discovered and further used by the trained model. Once the model is trained, it may be used to give predictions based on insights learned from the data, for example.

US 10212261 B2 discloses wireless sensor nodes for enabling network connectivity in a wireless sensor network system.

US 2021/049460 A1 discloses methods, systems and machine-readable storage media for automatically controlling enterprise and industrial processes.

SUMMARY

Previous work related to embedding AI-based solutions into the IoT sensor network has focused on creating three dimensional (3D) simulations of the IoT network environment. One example of such work is Moriyama, Takao, et al. "Reinforcement learning testbed for power-consumption optimization." Asian Simulation Conference. Springer, Singapore, 2018. The publication is based on EnergyPlus, a program developed by the U.S. Department of Energy for simulating energy consumption in buildings. The program takes as input 3D-models of buildings, as well as data such as weather, expected personnel movement and window insulation specifics. In this work, the authors propose to connect a simulation platform to a control system based on a deep reinforcement learning by using a simulation wrapper. Such approach however requires arduous designing of spaces to mimic real IoT network functionality. The designer is also restricted by the components available in the simulation platform, which means that intricacies present in the IoT sensor network might not be correctly presented in the simulation. Moreover, this approach requires a number of software packages which are difficult to install on the server used to for the tests. In summary, creating a simulation using this approach is very slow, and depending on the circumstances may even take 1-2 weeks. Furthermore, the scalability of such a system is poor.

The current LwM2M standard defines operations that may be executed on LwM2M Resources and Objects as: read, write, execute, and observe. However, the same LwM2M standard specification does not support or facilitate any operations related to artificial intelligence. The machine learning model by itself does not recognise what nature does each of the parameters measured by the LwM2M sensor have. In particular, the machine learning model does not by itself distinguish between the parameters that may actually be controlled and the parameters that are completely outside of any control and/or which indicate an independent state of the system, for example. For this reason, any machine learning system working with such data needs to be carefully designed and configured by a human designer, e.g. by organising which parameters or metrics of the sensor data should form part of the input to the machine learning model, and which parameters or metrics of the sensor data should form part of the output, depending on the use case. The consequence of that is the time to train the machine learning models using sensor data provided by the LwM2M clients becomes very long.

It is therefore an object of the present invention to overcome the issues identified above.

According to the first aspect of the present invention, there is provided a method as set out in claim 1.

According to the second aspect of the present invention, there is provided a server node implementing a Lightweight Machine-to-Machine, LWM2M protocol. The server node is configured to perform operations according to the first aspect.

According to the third aspect of the present invention, there is provided a computer program comprising program code to be executed by processing circuit of a server node, whereby execution of the program code causes the server node to perform operations according to the first aspect.

Advantageously, various embodiments reduce time required to perform training of a machine learning models working on large amounts of data collected from IoT sensors in IoT environments. In particular, various embodiments allow training of machine learning models in much shorter time intervals e.g in seconds instead of weeks or months. Various embodiments further provide good compromise between low validation loss and quick execution time. Further, various embodiments allow mimicking the interaction between different parameters in the data. Furthermore, various embodiments enable massive scaling, as agents and environments which comply to the standard can easily be pitted against other agents and benchmarked in the same environments, reducing time needed to custom fit for a specific solution. Furthermore, various embodiments improve the control, operational performance, flexibility and robustness of any solution incorporating embodiments of the present invention, such as simulators of dynamic systems or the dynamic systems themselves, as exemplified in the detailed description below.

BRIEF DESCRIPTION OF DRAWINGS

The present disclosure is described, by way of example only, with reference to the following figures, in which:

Figure 1 is a simplified illustration of an interaction cycle between a reinforcement learning (RL) agent and the environment.

Figure 2 illustrates some of the entities defined by the LwM2M protocol.

Figure 3 is a flowchart illustrating steps of the method according to some embodiments.

Figure 4 is a flowchart illustrating a simplified processing from collection of the data to training a neural network inside a digital twin, according to some embodiments.

Figure 5 is a block diagram illustrating an interaction cycle between a reinforcement learning (RL) agent and the environment, according to some embodiments.

Figure 6 is a flowchart illustrating the training of the neural network according to some embodiments.

Figure 7 is a block diagram illustrating training and validation of a neural network according to some embodiments.

Figure 8 illustrates the interaction between the environment and the agent in the context of the data center example use case.

Figure 9 illustrates an example neural network.

Figure 10 illustrates an example dataset annotated according to some embodiments.

Figures 11a and 11b are block diagrams illustrating server nodes according to some embodiments.

Figure 12 is a block diagram illustrating elements of the system according to some embodiments.

DETAILED DESCRIPTION

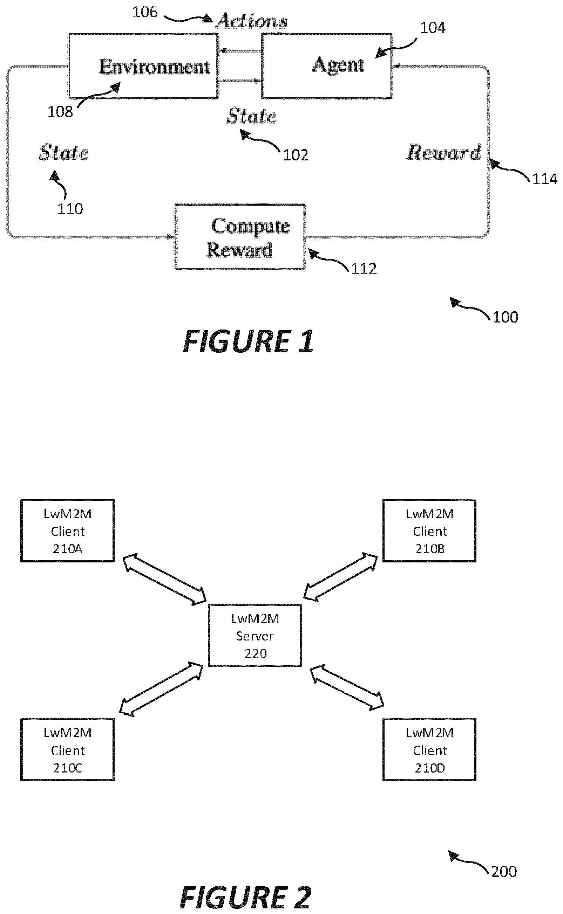

Figure 1 is a simplified illustration of an interaction cycle between a reinforcement learning (RL) agent 104 and an environment 108. RL is a machine learning technique that involves training an agent 104 to best optimise their reward 114 within a given environment 108. A reward 114 may be a scalar, where a higher value of the scalar indicates better performance of the agent 104 and a lower value of the scalar indicates poorer performance of the agent 104. At step 102, the environment 108 outputs its current state 102 that is observed by the agent 104. At step 104, the agent takes actions based on the current state 102 of the environment 108. At step 106, the actions are forwarded to the environment 108. At step 108, the environment executes the actions and moves to a new state 110. Based on the new state 110, a reward is computed at step 112. At step 114, the computed reward is returned to the agent 104, which calibrates future actions, based on the reward 114 it received.

A reward may be a scalar which the agent seeks to maximise. The reward may be for the next timestep, but also the cumulative reward over an entire run. In some examples, a return may be computed which sums up all rewards achieved in a run. The return may also include a discount factor that lessens the impact of rewards into the future on the currently chosen actions. The example of a return calculation involving the discount factor is shown in equation 1.

$$R(\tau) = \sum_{t=0}^{T} \gamma^t r_t \ (1)$$

In the above equation, $\gamma$ represents the discount factor. The discount factor is always a number $0 \le \gamma \le 1$. The reward is represented by r. $T$ corresponds to the time horizon and t is a given time step. Based on the expected return, a value function may be computed which estimates the value of a certain state for the agent to be in or the value of an action in a certain state.

Figure 2 illustrates some of the entities defined by the LwM2M protocol. LwM2M protocol defines three components. A first one is a LwM2M Client 210A, 210B, 210C, 210D, which may contain a plurality of LwM2M Objects. Each LwM2M Object may contain a plurality of LwM2M Resources. LwM2M Server 220 can execute commands on these Resources to manage the client. The commands may include reading, deleting or updating the resources. LwM2M Clients are commonly implemented in constrained devices or nodes, for example as defined in Internet Engineering Task Force (IETF) Request for Comments (RFC) 7228 "Terminology for Constrained-Node Networks". A second component is a LwM2M Server 220 which manages LwM2M Clients by sending management commands to them. A third component is LwM2M Bootstrap Server which is used to manage the initial configuration parameters of LwM2M Clients during bootstrapping.

To maintain the communication between the components above, the following LwM2M interfaces are defined. With Bootstrapping interface, the LwM2M Bootstrap Server sets the initial configuration on LwM2M Client when the client device bootstraps. There are four different bootstrapping methods: Factory Bootstrap, Bootstrap from Smartcard, Client Initiated Bootstrap and Server Initiated Bootstrap. A Client Registration interface involves LwM2M Client registering to one or more LwM2M Servers when the bootstrapping is completed. With Device Management and Service Enablement interface, the LwM2M Server can send management commands to LwM2M Clients to perform several management actions on LwM2M resources of the client. Access control object of the client determines the set of actions the server can perform. Information Reporting interface is a feature of CoAP Observe-Notify mechanism. LwM2M Clients can initiate the communication to LwM2M Server and report information in the form of notifications.

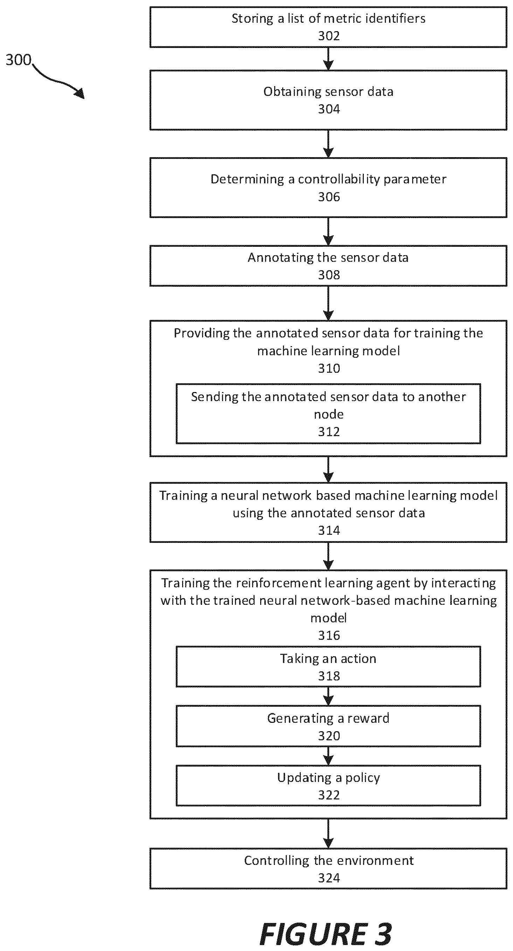

Figure 3 illustrates a method 300 of operating a server node according to some embodiments. The server node implements a Lightweight Machine-to-Machine, LwM2M protocol. At step 304, sensor data 712 is obtained, the sensor data comprising values of a metric 712a ... 712g measured in an environment 510 by a client node 1212a ... 1212d implementing the LWM2M protocol. The metric 712a ... 712g may comprise, for example, a physical parameter, such as temperature or humidity. The metric may also comprise other types of parameters, such as air quality, pressure, and many others. The metric may also comprise a configurable parameter of a system, such as a setpoint of a fan speed and the like.

The environment 1210 may comprise a dynamic system 1210, wherein the dynamic system 1210 comprises one or more sensors or actuators operating in a communications network. The dynamic system 1210 may comprise, for example, a data centre for storing, management, and processing large amounts of data. The dynamic system may also comprise, for example, a communications network.

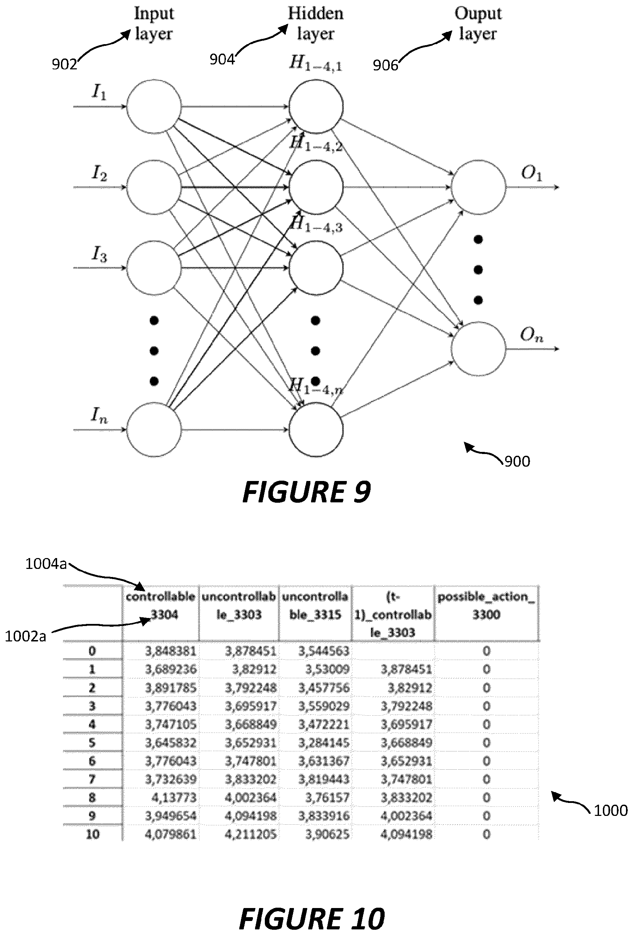

The obtained sensor data further comprises a metric identifier 1002a. The metric identifier 1002a may uniquely identify the metric 712a ... 712g and may be a number, for example a number "3304" as illustrated by reference numeral 1002a on figure 10. At step 306, a controllability parameter value 1004a is determined based on the metric identifier, the controllability parameter value representing an extent of controllability of the metric 712a ... 712g by a reinforcement learning agent operating on the environment. In particular, the controllability parameter values may be selected from a group comprising four categories. A first category 406C may indicate that the associated metric is indirectly controllable by the reinforcement learning agent. The metric of the first category 406C may comprise, for example, e.g. a temperature of certain zones or a total power consumption. A second category 406A may indicate that the associated metric is not controllable by the reinforcement learning agent. The metric of the second category 406A may comprise, for example, a day of a year when the data was logged, or outside temperature. The second category represents outside factors, which are given to the agent and which are uncontrollable by the agent. A third category 406B may indicate that the associated metric is directly controllable by the reinforcement learning agent. The metric of the third category may comprise, for example, a fan speed or other setpoints. The third category represents parameters which the agent can directly control through its decisions. An agent may be configured to only take actions that are within the ranges of the highest and lowest recorded parameter settings so as to avoid going out of the bounds of the data and into unexplored ranges of the simulation environment. A fourth category 406D may indicate that the values of the associated metric are measured at a first time instance $t - 1$, wherein the first time instance $t - 1$ is preceding a second time instance t at which values of the metric associated with the first category were measured.

At step 302, a list of metric identifiers and respective controllability parameter values may be stored. In particular, each metric identifier may correspond to a LwM2M Object stored in a LwM2M registry, and each controllability parameter value may correspond to a LwM2M Resource stored in the LwM2M registry for the respective LwM2M Object.

In particular, LwM2M schema may be extended by introducing a new categorization parameter for resources in LwM2M objects. This categorization parameter is expected to be used by ML/AI applications for improved training of machine learning models, such as neural networks. LwM2M schema is part of the LwM2M and it specifies how LwM2M objects and resources should be created by defining e.g. mandatory fields for LwM2M objects such as object name, Object ID, Object URN, and mandatory fields for LwM2M resources such as resource name, allowed operations, data type of the resource. According to the embodiments, a new optional parameter in LwM2M schema may be introduced for LwM2M resources so that the resource can be categorized for ML/AI purposes. For illustration, one way this can be performed is by adding to the LwM2M schema the following fields inside "Resources" parent element, according to Table 1 below:

*Table 1 LwM2M Resources element with new fields corresponding to controllability parameter values*

```
<xs:element name="Categorization" >
<xs:simpleType>
<xs:restriction base="xs:string">
<xs:enumeration value="Uncontrollable"/>
<xs:enumeration value="Controllable"/>
<xs:enumeration value="Possible action"/>
<xs:enumeration value=" "/>
</xs:restriction>
</xs:simpleType>
</xs:element>
```

For example, described in Table 2 below, is an object definition of Object ID 3303 Temperature. Only the beginning of the object definition is presented. The field "Categorization", the name of which is only an example and may change, may be used to store a controllability parameter value associated with the "Temperature" metric. In the example of Table 2, LwM2M defines a "Temperature" parameter, having Object ID 3303. The "Temperature" object comprises a Resource having a Resource ID of 5700 and defining a "Sensor Value" as the "Last Current Measured Value from the Sensor". The Resource within the "Temperature" object is categorised as "uncontrollable", which corresponds to a metric of the second category. This indicates that the Sensor Value 5700 of the parameter Temperature represents an outside factor and is not controllable by the reinforcement learning agent.

As a consequence, any LwM2M server receiving a value from any LwM2M client on this Resource of this Object, the LwM2M server can immediately process the value as "uncontrollable". This removes the need for manual categorization of data for machine learning or artificial intelligence applications since the categorization will be embedded to the data structure itself.

*Table 2 Example definition of controllability parameter in LwM2M*

```
<LWM2M xmlns:xsi="http://www.w3.org/2001/XMLSchema-instance"
xsi:noNamespaceSchemaLocation="http://openmobilealliance.org/tech/
profiles/LWM2M.xsd">
        <Object ObjectType="MODefinition">
                <Name>Temperature</Name>
                 <Descriptionl>This IPSO object should be used with a
temperature sensor to report a temperature measurement. It also
provides resources for minimum/maximum measured values and the
minimum/maximum range that can be measured by the temperature
sensor. An example measurement unit is degrees
Celsius.</Descriptionl>
                        <ObjectID>3303</ObjectID>
                        <ObjectURN>urn:oma:lwm2m:ext:3303:1.1</ObjectURN>
                        <LWM2MVersion>1.0</LWM2MVersion>
                        <ObjectVersion>1.1</ObjectVersion>
                        <MultipleInstances>Multiple</MultipleInstances>
                        <Mandatory>Optional</Mandatory>
                        <Resources>
                                <Item ID="5700">
                                        <Name>Sensor Value</Name>
                                         <Operations>R</Operations>
                                        <MultipleInstances>Single</MultipleInstanc
es>
                                        <Mandatory>Mandatory</Mandatory>
                                        <Type>Float</Type>
                                        <RangeEnumeration></RangeEnumeration>
                                        <Units></Units>
                                        <Description>Last or Current Measured
Value from the Sensor.</Description>
                                        <Categorization>Uncontrollable</Categoriza
tion>
                                </Item>
        ....
        ....
                        </Resources>
                </Object>
        </LWM2M>
```

The controllability parameter value may be determined based on a comparison of the metric identifier with the metric identifiers in the list. In particular, the metric identifier collected from the obtained sensor data, such as Object ID 3303 for the Temperature data, may be used to identify the data structure describing the "Temperature" parameter in the list, such as LwM2M registry. For example, the Object ID 3303 may be used to look up the same Object ID in the LwM2M registry of data structures describing the parameters registered in the LwM2M. When there is a match after comparison of the two Object IDs, a field dedicated to storing the controllability parameter value in the data structure is accessed to determine the controllability parameter value for this parameter or metric represented by the Object ID. In the example of Table 2, when the Object ID 3303 matches Object ID field value, the "Categorisation" field is accessed, which stores a value "Uncontrollable" that corresponds to the second category of controllability parameter values.

As a simple illustrating example, a primitive function may be called and may take as input Object IDs associated with respective metric.

```
categorization-primitive(inputs(3303, 3304, 3315, 3300, 3200), output)
```

One the above categorization-primitive is executed, the following output may be obtained.

```
(Ambient Temperature, Object ID 3303, Resource ID 5700, UnControllable)
(Humidity, Object ID 3304, Resource ID 5700. Controllable)
(Barometer, Object ID 3315, Resource ID 5700, UnControllable)
(Air Quality, Object ID 3300, Resource ID 5700, Possible Action)
(Actuation, Object ID 3306, Resource ID 5850, Controllable)
```

Figure 10 illustrates an example table 1000 with sensor data annotated as described below. At step 308, the sensor data is annotated with the determined controllability parameter value 1004a. For example, the label 1002a indicating the Object ID of the metric, name of the metric being measured or any other identification of the list of sensor metric values, may be extended by adding the controllability parameter value 1004a. It will be appreciated however that this is an example only, and other ways of annotating, appending or adding the controllability parameter value to the obtained sensor data may be possible.

At step 310, the annotated sensor data is provided for training the machine learning model 1224 simulating the environment. In some situations, it may not be desirable or even feasible to reconfigure or test out new parameters directly on the real environment 1210. When the environment 1210 is a live dynamic system 1210, such as an operating data centre, reconfiguration or tuning of some parameters into certain ranges may result in erroneous operation of the dynamic system. For example, slowing down a speed of fans which cool the servers may increase the temperature of the electronic components of the servers. This, in some circumstances, may result in devastating overheating and consequently physical damage, that may seriously affect the operation of the data centre. For this reason, it is often desirable to try out certain actions on the simulated version 1224 of the environment 1210. Such simulators, otherwise known as digital twins, are the virtual representation of a physical object or system across its lifecycle. They use real-time data and other sources to enable learning, reasoning, and dynamically recalibrating for improved decision making. Digital twins may comprise machine learning model 1224 or a set of machine learning models. The LwM2M server 1222 may therefore provide the annotated sensor data to train, at step 314, such a machine learning model 1224. The machine learning model 1224 may be co-located with the LwM2M server 1222 on the same machine, node or virtual resource, or alternatively may be operating in a separate node, machine or virtual resource, in which case the annotated sensor data may be sent from the LwM2M server 1222 to another node, at step 312.

The model 1224 may be based on a neural network 1224. It will be appreciated however that other models may be used, for example linear function approximators with basis functions, such as Fourier basis functions, polynomes, radial basis functions etc. In some examples, the annotated sensor data may comprise values of a metric of the first category and values of a metric of the at least one of the second category, third category or the fourth category, and the trained neural network-based machine learning model may be configured to predict values of a metric of the first category.

Once the neural network 1224 is trained, at step 316, a reinforcement learning agent may be used to interact with the trained machine learning model 1224 simulating the environment 1210. The agent 1226 observes or collects data on the current state of the environment 1220, and based on the current state, at step 318, takes an action on the simulated environment 1224. The action corresponds or is taken on a metric of a third category. Based on the action and any additional data, the environment 1220 computes the next state. A reward is then generated, at step 320, by the environment 1220 based on a reward function, for example. The reward may be generated based on a metric of the first category. The reward is forwarded then to the agent which may update its policy, at step 322, based on the reward. The cycle is then finished.

At step 324, the real environment 1210 may be controlled using the trained reinforcement learning agent 1226 based on the updated policy. In some examples, the trained reinforcement learning agent 1226 may be deployed to directly act on the live dynamic system 1210, such as an operating data centre 1210. Having been previously trained on the simulated environment 1220, the actions taken by the agent 1226 are deemed more reliable and safer.

An example of how some embodiments operate will be shown below, although it is appreciated that the below use case is illustrating only, and it is not intended to be limiting.

Data centers are subject to three percent of the power consumption in the world, which is not a sustainable situation in the long term. There is therefore a need to optimise power consumption at data centers and increase their energy efficiency. This may be achieved by simulating the data center IoT environment and then by training the RL model based on specific parameter characterisation.

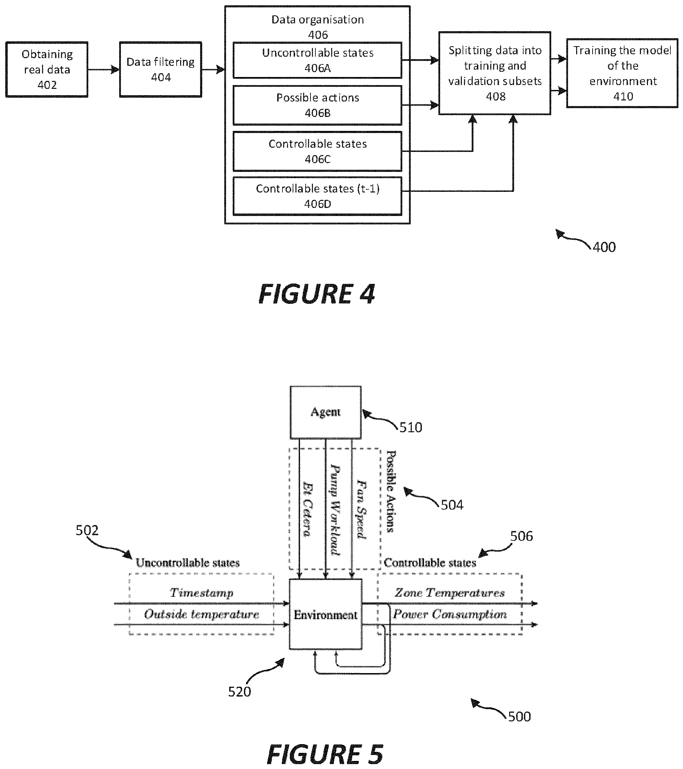

Figure 4 illustrates a simplified flow of processing from collection of the data to training a neural network inside a digital twin. In this example, a neural network may be trained using 65000 rows and 79 columns of data in less than 100 seconds, which is a significant reduction compared to weeks or months in prior art solutions. At step 402, data is collected from a data centre. The data may be a historical data received from a suitable store, such as a memory, or live data received in on-line fashion. The data may include data needed by the neural network, for example a mixture of multiple IoT sensors data using obtained suing LwM2M protocol, and also other data not required by the neural network, such as zeros, and NaN data. The data was collected from 79 IoT sensors over a period of two years. All sensor readings have been timestamped and can thereby be merged to a large table. The data in the set was sampled every 10 minutes, from 11:10 January 2nd 2018 to 23:50 April 19th 2019. After some data engineering, where rows containing NaN values and erroneous readings are taken out, the two-dimensional set contains 68040 rows. The data can be split up into seven categories:

- local timestamp (1 sensor): the time at which the sensors were sampled;
- outside air temperature (4 sensors): the temperature at different altitudes and sections outside of the data center;
- pump: describes the workload of different pumps:

  ○ P1- Pump to the chillers (3 sensors): pumps which pump the water to the chillers on the roof;
  ○ P2 - Pump from the district cooling cycle: pumps from the district cooling cycle, data not available, but is part of data center function;

- P3 - Pump to the Crac units (3 sensors): pumps to the Crac units;
- P4 - Pressure of the pumps (10 sensors): pressure of pumps used to pump water to roof;

- P5 - Parameters for heat exchange (36 sensors): parameters for the heat exchange machines, which transfer heat from the warmer water of the P3 cycle, 6 different setpoints for 6 compressors.
- rooftop chiller:

  - fans (10 sensors): the shaft speed of the rooftop fans;
  - valve (5 sensors): the openness of the valves in the water pipes to the fans, these are always open and should never be changed, and are omitted from the action and observation space;

- lab air temperature (3 sensors): the temperature in different server zones;
- power:

  - total power (1 sensor): the total power consumption in the data center;
  - Technical Equipment, TE power (1 sensor): the power used by the technical equipment, e. g. servers;
  - backup power (1 sensor): backup power supply in the form of batteries. Used when switching between operating modes or when normal power supply is cut;
  - mains power (1 sensor): power which has been provided by the intended (main) source of power. The power consumption when not using backup power;
  - power usage effectiveness, PUE: the power usage effectiveness of the data center, not actually measured by a sensor but computed with Total Power and TE power.

At step 404 data filtering is performed which removes the data not required by the neural network, such as zeros and NaN data. Once filtering is performed, the remaining mixture of multiple IoT sensors data including timestamps are categorized, at step 406, into different categories or controllability parameter values:

- uncontrollable states: states which the agent can never control, such as day of year or weather. In our case these include the day of the year, outside temperature.
- possible actions: actions which the agent directly controls, such as fan speeds or pump workload;
- controllable states: states which the agent controls indirectly, such as power consumption and temperature of certain zones;

The output of step 406 is an array of rows and columns where columns include sensors e.g. uncontrollable state sensors, controllable state sensors, possible action sensors, controllable states (t -1) sensors, and where rows include sensor data classified in time e.g. all sensors data in *t1*, all sensor data in *t2*, etc.

Figure 5 describes how the controllable states from the previous timestep are input into the neural network. It can be assumed that the power consumption of the data center or the temperature of a given zone would be affected by the values 10 minutes prior. The agent 510 performs actions 504 on the simulated environment 520. The actions include reconfiguring fan speed or pump workload. The simulated environment 520 also takes as input uncontrollable states 502, such as timestamp and outside temperature. The controllable states 506 are output from the simulated environment 520, and are also fed back to it from the previous timestep as input.

At step 408, the output of the data organisation step 406 is randomly split into training and validation data. The percentage of the training and validation data may be selected according to a particular scenario. For example, the data may be split into 90% of training and 10% validation data, however other arrangements may be possible, such as 80% training data and 20 % validation data. At step 410, the training data and validation data are provided to the neural network for training.

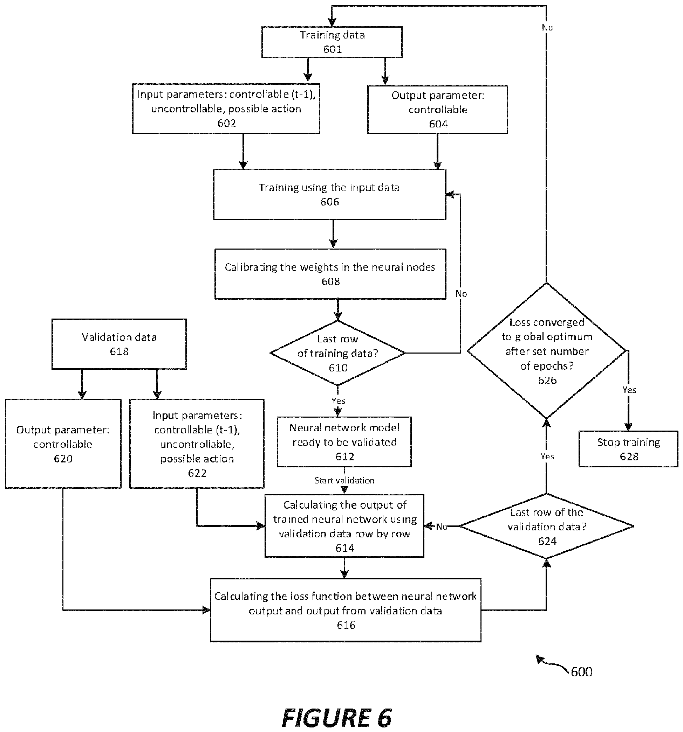

Figure 6 shows a flowchart illustrating the training of the neural network. The training data 601 that comprises input parameters 602: controllable (t-1) metric (fourth category), uncontrollable (second category), possible action (third category), and output parameter 604: controllable (first category). The neural network is then trained using the input parameters row by row. The training data may be shuffled while keeping the row structure, to achieve a better training result. The shuffling is enabled by the controllable (t-1) metric (fourth category). At step 608, the weights in the neural nodes of the neural network are calibrated. At step 610, the check is made whether the processed row was the last row of the training data. If not, then steps 606 and 608 are repeated. If yes, then the neural network model is ready to be validated using the validation data 618 is started. At step 622, sensor data comprising the metrics categorised as possible action, uncontrollable, controllable (t-1) are fed to the trained neural network. The neural network then generates an output value A at step 614 based on the input data. At step 616, based on the value A, a loss function is calculated with the controllable sensor data in the first row. The calculation of the loss function can be made using for example mean absolute error method. The steps 614 and 616 are repeated until last row of the validation data is reached at step 624. After processing of the next row of validation data, an output value B is generated by the neural network. The loss function is then recalculated based on the value B. Once all the validation rows are processed, a check is made at step 626 whether the loss has converged to a global optimum after a set number of epochs. If the recalculated loss is larger than a threshold loss value that may be set manually, the neural network needs to be retrained and all the rows of the training and validation data in an epoch need to be re-run. If the calculated loss is equal or less than the threshold value, then the training is stopped at step 628.

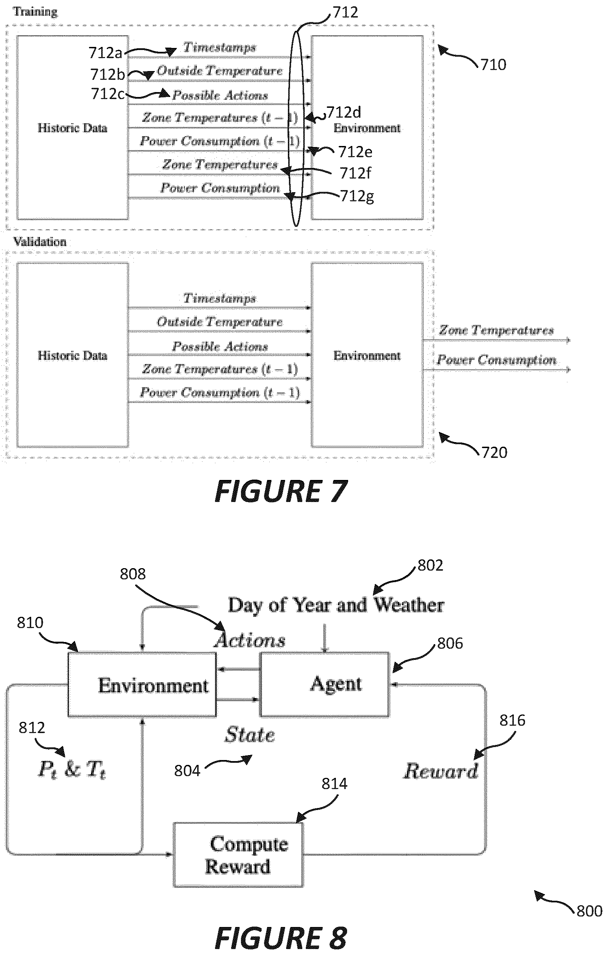

Figure 7 shows another perspective on the training 710 and validation 720 the neural network and the specific parameters used in these processes. When the environment is trained, it is fed with all the sensor data. During validation, the controllable states i.e. "Zone Temperatures" and "Power Consumption", are predicted using the uncontrollable states, the possible actions and the controllable states (t-1).

Figure 8 in turn shows the interaction 800 between the environment and the agent in the context of the data center example use case. At step 802, a random timestep in the data is chosen, for which the day of the year and the outside temperature readings are forwarded to the agent 806 and simulated environment 810. At step 804, the simulated environment 810 is initialised with the state as it was at that specific time. The agent 806 receives the data of the current state and chooses an action accordingly. The actions are fed to the environment 810 at step 808. The environment 810 computes the next state based on the day of year, weather and the actions. The environment 810 outputs, at step 812, the current power consumption $P_t$ and zone temperatures $T_t$ to compute the reward 816 at step 814, and also feeds it back to itself to compute the next state. The computed reward 814 is forwarded to the agent 806 and then the cycle is finished.

The environment 810 computes a reward function, which is used for the reinforcement learning agent to determine whether the results of its actions are desirable or not. The total reward function used in this work consists of a temperature part and a power consumption part.

$$r_t = r_T + \lambda_P * r_P \quad (2)$$

In the above equation, the reward is based both upon the deviation from desired temperature, $r_T$, and the power consumption in the data center, $r_P$, weighted by $\lambda_P$, a hyper-parameter which is important to balance.

$$r_T = \sum_{i=1}^{z} e^{-\lambda_1 \left(T_t^i - T_c^i\right)^2} - \lambda_2 \sum_{i=1}^{z} ([T_t^i - T_U^i] + [T_L^i - T_t^i]) \quad (3)$$

In equation 3, $z$ is the number of data center zones, $\lambda_1$ and $\lambda_2$ are weight hyper-parameters, $T_t^i$ is the current temperature in a certain zone, $T_U^i$ and $T_L^i$ is the upper and lower boundary temperature respectively for a certain zone. The exponential term in the temperature part of the reward function comprises a bell-shaped reward and the second term comprises a trapezoid reward. The bell-shaped reward quickly converges towards 0 once the temperature deviates too much. The trapezoid part however, behaves in a linear manner and has discernible values for all temperatures, meaning a reward can always be inferred.

$$r_P = -P_t \quad (4)$$

Equation 4 shows how the power consumption at the current timestep, Pt, is penalised in the reward function. As shown in figure 8, when the environment is trained it is fed with all the data. During validation, the controllable states, "Zone Temperatures" and "Power Consumption", are predicted using the uncontrollable states, the possible actions and the controllable states (t-1).

The simulated environment may comprise a neural network 900, the example of which is illustrated in figure 9. The neural network may comprise an input layer 902 which may comprise a plurality of inputs $I_1$ to $I_n$ configured to receive data. The number of input neurons may correspond to a desired number of parameters for the simulation to include. The neurons in the input layer are connected with neurons $H_{1-4,l}$ to $H_{1-4,n}$ in further, hidden layers, such as a hidden layer 904. There may be more than one hidden layer and the actual number of layer is configurable. The last hidden layer may be connected with the output layer 906 containing neurons that produce the output $O_1$ to $O_n$. In particular, the neural network 900 may comprise 4 layers of neurons, which may provide a good compromise between low validation loss and quick execution time.

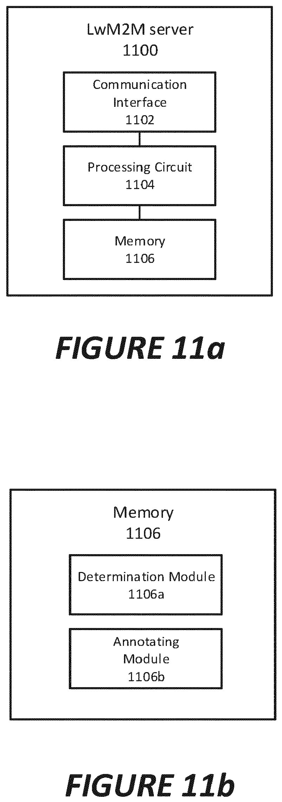

Figure 11a is a block diagram of a server node 1100, such as a LwM2M server 1100 which implements LwM2M protocol. Various embodiments provide a server node 1100 that includes a processing circuit 1104, a communication interface 1102 coupled to the processing circuit 1104, and a memory 1106 coupled to the processor circuit 1104. The memory 1106 includes machine-readable computer program instructions that, when executed by the processor circuit, cause the processing circuit 1104 to perform some of the operations depicted described herein.

As discussed herein, operations of the LwM2M server 1100 may be performed by processing circuit 1104 and/or communication interface 1102. For example, the processing circuit 1104 may control the communication interface 1102 to transmit or receive communications through the communication interface 1102 to or from one or more other devices, nodes, interfaces. Moreover, modules may be stored in memory 1106, and these modules may provide instructions so that when instructions of a module are executed by processing circuit 1104, processing circuit 1104 performs respective operations (e.g., operations discussed herein with respect to example embodiments).

In some embodiments, the LwM2M server 1100 uses the communication interface 1102 to obtain sensor data comprising values of a metric measured in an environment by a client node implementing the LWM2M protocol, wherein the sensor data comprises a metric identifier. The communication interface 1102 then passes the obtained sensor data to the processing circuit 1104 which, in conjunction with the memory 1106 and based on the metric identifier, determines a controllability parameter value representing an extent of controllability of the metric by a reinforcement learning agent operating on the environment. The processing circuit then annotates the sensor data with the determined controllability parameter value and provides the annotated sensor data for training the machine learning model simulating the environment.

In various embodiments, the memory 1006 may comprise a determination module 1106a that, based on the metric identifier, determines a controllability parameter value representing an extent of controllability of the metric by a reinforcement learning agent operating on the environment. The annotating module 1106 then annotates the sensor data with the determined controllability parameter value.

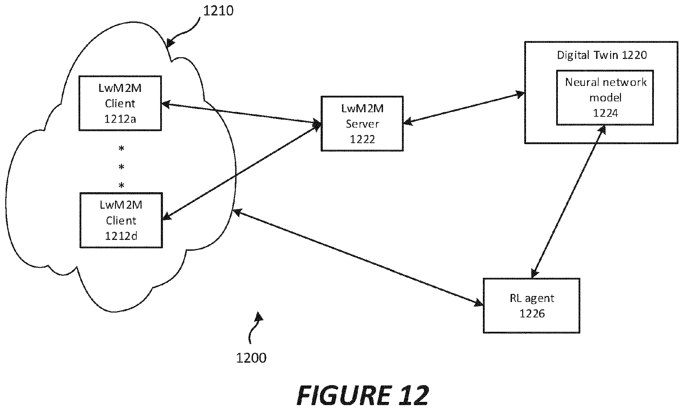

Figure 12 illustrates a block diagram of a complete system 1200 according to some embodiments. The LwM2M clients 1212a ... 1212d may be located within the real environment 1210 such as a dynamic system 1210 like data center 1210 or live communications network 1210 to perform measurements, collect data and forward it to the LwM2M server 1222, for example over a network connection. The LwM2M server 1222 may be remote to the environment, or may be alternative located within the same environment, i.e. in the same computing infrastructure or system. The LwM2M server 1222 may provide the collected sensor data, processed according to some of the embodiments described above, to the digital twin 1220. The digital twin 1220 may comprise a machine learning model 1224, such as a neural network model 1224 that simulates the operation of the environment 1210. Once the model 1224 is trained, the RL agent 1226 may be trained by interacting with the trained neural network model 1224, as described above in detail. The RL agent 1226 once trained, may be deployed to control the real environment 1210, for example by reconfiguring, optimizing a dynamic system 1210 such as a data center or a communications network. It will be appreciated that the LwM2M server 1222 may be co-located in the same physical or virtual node as the real environment 1210 or digital twin 1220. It will be also appreciated that both the digital twin 1220 and LwM2M server are part of the same physical or virtual infrastructure as the real environment 1210.

In the above description of various embodiments of present inventive concepts, it is to be understood that the terminology used herein is for the purpose of describing particular embodiments only and is not intended to be limiting of present inventive concepts. Unless otherwise defined, all terms (including technical and scientific terms) used herein have the same meaning as commonly understood by one of ordinary skill in the art to which present inventive concepts belong. It will be further understood that terms, such as those defined in commonly used dictionaries, should be interpreted as having a meaning that is consistent with their meaning in the context of this specification and the relevant art.

When an element is referred to as being "connected", "coupled", "responsive", or variants thereof to another element, it can be directly connected, coupled, or responsive to the other element or intervening elements may be present. In contrast, when an element is referred to as being "directly connected", "directly coupled", "directly responsive", or variants thereof to another element, there are no intervening elements present. Like numbers refer to like elements throughout. Furthermore, "coupled", "connected", "responsive", or variants thereof as used herein may include wirelessly coupled, connected, or responsive. As used herein, the singular forms "a", "an" and "the" are intended to include the plural forms as well, unless the context clearly indicates otherwise. Well-known functions or constructions may not be described in detail for brevity and/or clarity. The term "and/or" includes any and all combinations of one or more of the associated listed items.

It will be understood that although the terms first, second, third, etc. may be used herein to describe various elements/operations, these elements/operations should not be limited by these terms. These terms are only used to distinguish one element/operation from another element/operation. Thus, a first element/operation in some embodiments could be termed a second element/operation in other embodiments without departing from the teachings of present inventive concepts. The same reference numerals or the same reference designators denote the same or similar elements throughout the specification.

As used herein, the terms "comprise", "comprising", "comprises", "include", "including", "includes", "have", "has", "having", or variants thereof are open-ended, and include one or more stated features, integers, elements, steps, components, or functions but does not preclude the presence or addition of one or more other features, integers, elements, steps, components, functions, or groups thereof.

Example embodiments are described herein with reference to block diagrams and/or flowchart illustrations of computer-implemented methods, apparatus (systems and/or devices) and/or computer program products. It is understood that a block of the block diagrams and/or flowchart illustrations, and combinations of blocks in the block diagrams and/or flowchart illustrations, can be implemented by computer program instructions that are performed by one or more computer circuits. These computer program instructions may be provided to a processor circuit of a general purpose computer circuit, special purpose computer circuit, and/or other programmable data processing circuit to produce a machine, such that the instructions, which execute via the processor of the computer and/or other programmable data processing apparatus, transform and control transistors, values stored in memory locations, and other hardware components within such circuitry to implement the functions/acts specified in the block diagrams and/or flowchart block or blocks, and thereby create means (functionality) and/or structure for implementing the functions/acts specified in the block diagrams and/or flowchart block(s).

These computer program instructions may also be stored in a tangible computer-readable medium that can direct a computer or other programmable data processing apparatus to function in a particular manner, such that the instructions stored in the computer-readable medium produce an article of manufacture including instructions which implement the functions/acts specified in the block diagrams and/or flowchart block or blocks. Accordingly, embodiments of present inventive concepts may be embodied in hardware and/or in software (including firmware, resident software, micro-code, etc.) that runs on a processor such as a digital signal processor, which may collectively be referred to as "circuitry," "a module" or variants thereof.

It should also be noted that in some alternate implementations, the functions/acts noted in the blocks may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of inventive concepts. Moreover, although some of the diagrams include arrows on communication paths to show a primary direction of communication, it is to be understood that communication may occur in the opposite direction to the depicted arrows.

## Claims

1. A method (300) of operating a server node implementing a Lightweight Machine-to-Machine, LWM2M, protocol, the method comprising:

    storing (302) a list of metric identifiers and respective controllability parameter values;
    obtaining (304) sensor data comprising values of a metric measured in an environment by a client node implementing the LWM2M protocol, wherein the sensor data further comprises a metric identifier;
    based on the metric identifier, determining (306) a controllability parameter value representing an extent of controllability of the metric by a reinforcement learning agent operating on the environment, wherein the controllability parameter value is determined based on a comparison of the metric identifier with the metric identifiers in the list and
    wherein the respective controllability parameter values are selected from a group comprising:

        a first category indicating that the associated metric is indirectly controllable by the reinforcement learning agent;
        a second category indicating that the associated metric is not controllable by the reinforcement learning agent;
        a third category indicating that the associated metric is directly controllable by the reinforcement learning agent;
        a fourth category indicating that the values of the associated metric are measured at a first time instance, wherein the first time instance is preceding a second time instance at which values of the metric associated with the first category were measured;

    annotating (308) the sensor data with the determined controllability parameter value;
    providing (310) the annotated sensor data for training a machine learning model simulating the environment, wherein the machine learning model is a neural network-based machine learning model and wherein providing the annotated sensor data for training a machine learning model simulating the environment comprises:
    training (314) the neural network-based machine learning model using the annotated sensor data; and
    training (316) the reinforcement learning agent by interacting with the trained neural network-based machine learning model.

2.   A method according to claim 1, wherein each metric identifier corresponds to a LwM2M Object stored in a LwM2M registry, and wherein each controllability parameter value corresponds to a LwM2M Resource stored in the LwM2M registry for the respective LwM2M Object.

3.   A method according to any preceding claim, wherein providing the annotated sensor data for training the machine learning model comprises:
sending (312) the annotated sensor data to another node implementing the machine learning model.

4.   A method according to any of the preceding claims, wherein the annotated sensor data comprises values of a metric of the first category and values of a metric of the at least one of the second category, third category or the fourth category, and wherein the trained neural network-based machine learning model is configured to predict values of a metric of the first category.

5.   A method according to any of the preceding claims, wherein training the reinforcement learning agent comprises:

taking (318) an action on the trained neural network-based machine learning model using the reinforcement learning agent, wherein the action is performed on a metric of the third category;
generating (320) a reward value using the machine learning model responsive to taking the action, wherein the reward value is based on a metric of the first category;
updating (322) a policy of the reinforcement learning agent based on the reward value.

6.   A method according to claim 5, further comprising controlling (324) the environment using the trained reinforcement learning agent based on the updated policy.

7.   A method according to claim 6, wherein the environment comprises a dynamic system, wherein the dynamic system comprises one or more sensors or actuators operating in a communications network.

8.   A server node (1100) implementing a Lightweight Machine-to-Machine, LWM2M, protocol, the server node (1100) configured to:

store (302) a list of metric identifiers and respective controllability parameter values;
obtain (304) sensor data comprising values of a metric measured in an environment by a client node implementing the LWM2M protocol, wherein the sensor data further comprises a metric identifier;
based on the metric identifier, determine (306) a controllability parameter value representing an extent of controllability of the metric by a reinforcement learning agent operating on the environment, wherein the controllability parameter value is determined based on a comparison of the metric identifier with the metric identifiers in the list and wherein the respective controllability parameter values are selected from a group comprising:

a first category indicating that the associated metric is indirectly controllable by the reinforcement learning agent;
a second category indicating that the associated metric is not controllable by the reinforcement learning agent;
a third category indicating that the associated metric is directly controllable by the reinforcement learning agent;
a fourth category indicating that the values of the associated metric are measured at a first time instance, wherein the first time instance is preceding a second time instance at which values of the metric associated with the first category were measured;

annotate (308) the sensor data with the determined controllability parameter value;
provide (310) the annotated sensor data for training a machine learning model simulating the environment, wherein the machine learning model is a neural network-based machine learning model and wherein providing the annotated sensor data for training a machine learning model simulating the environment comprises:
train (314) the neural network-based machine learning model using the annotated sensor data; and
train (316) the reinforcement learning agent by interacting with the trained neural network-based machine learning model.

9.   The server node of claim 8, configured to perform operations according to any of claims 2 to 7.

10. A computer program comprising program code to be executed by processing circuit (1104) of a server node (1100), whereby execution of the program code causes the server node (1100) to perform operations according to any of Claims 1 to 7.

11. A system (1200) comprising:

a server node (1222) according to claims 8 or 9;
a machine learning model (1224) simulating the environment (1210), wherein the machine learning model is communicatively couplable with the server node;
a reinforcement learning agent (1226) communicatively couplable with the machine learning model and the environment;
wherein the server node (1222) provides the annotated sensor data for training the machine learning model (1224), and wherein the reinforcement learning agent (1226) is configured to control the environment (1210) based on the trained machine learning model.


**Patentansprüche**

1. Verfahren (300) zum Betreiben eines Serverknotens, der ein leichtgewichtiges Maschine-zu-Maschine-Protokoll, LWM2M-Protokoll, umsetzt, wobei das Verfahren Folgendes umfasst:

Speichern (302) einer Liste von metrischen Kennungen und jeweiligen Steuerbarkeitsparameterwerten;
Erlangen (304) von Sensordaten, die Werte einer Metrik umfassen, die in einer Umgebung durch einen Client-Knoten, der das LWM2M-Protokoll umsetzt, gemessen wird, wobei die Sensordaten ferner eine metrische Kennung umfassen;
basierend auf der metrischen Kennung, Bestimmen (306) eines Steuerbarkeitsparameterwertes, der ein Ausmaß der Steuerbarkeit der Metrik durch einen Reinforcement-Learning-Agenten, der in der Umgebung betrieben wird, darstellt, wobei der Steuerbarkeitsparameterwert basierend auf einem Vergleich der metrischen Kennung mit den metrischen Kennungen in der Liste bestimmt wird und wobei die jeweiligen Steuerbarkeitsparameterwerte ausgewählt sind aus einer Gruppe, die Folgendes umfasst:

eine erste Kategorie, die angibt, dass die zugehörige Metrik indirekt durch den Reinforcement-Learning-Agenten steuerbar ist;
eine zweite Kategorie, die angibt, dass die zugehörige Metrik nicht durch den Reinforcement-Learning-Agenten steuerbar ist;
eine dritte Kategorie, die angibt, dass die zugehörige Metrik direkt durch den Reinforcement-Learning-Agenten steuerbar ist;
eine vierte Kategorie, die angibt, dass die Werte der zugehörigen Metrik zu einem ersten Zeitpunkt gemessen werden, wobei der erste Zeitpunkt einem zweiten Zeitpunkt vorausgeht, zu dem Werte der Metrik, die zu der ersten Kategorie gehört, gemessen wurden;
Kommentieren (308) der Sensordaten mit dem bestimmten Steuerbarkeitsparameterwert;
Bereitstellen (310) der kommentierten Sensordaten zum Trainieren eines Maschinenlernmodells, das die Umgebung simuliert, wobei das Maschinenlernmodell ein auf einem neuronalen Netzwerk basierendes Maschinenlernmodell ist und wobei das Bereitstellen der kommentierten Sensordaten zum Trainieren eines Maschinenlernmodells, das die Umgebung simuliert, Folgendes umfasst:

Trainieren (314) des auf einem neuronalen Netzwerk basierenden Maschinenlernmodells unter Verwendung der kommentierten Sensordaten; und
Trainieren (316) des Reinforcement-Learning-Agenten durch Interagieren mit dem trainierten, auf einem neuronalen Netzwerk basierenden Maschinenlernmodell.

2. Verfahren nach Anspruch 1, wobei jede metrische Kennung einem LwM2M-Objekt entspricht, das in einem LwM2M-Register gespeichert ist, und wobei jeder Steuerbarkeitsparameterwert einer LwM2M-Ressource entspricht, die in dem LwM2M-Register für das jeweilige LwM2M-Objekt gespeichert ist.

3. Verfahren nach einem der vorhergehenden Ansprüche, wobei das Bereitstellen der kommentierten Sensordaten zum Trainieren des Maschinenlernmodells Folgendes umfasst:
Senden (312) der kommentierten Sensordaten an einen anderen Knoten, der das Maschinenlernmodell umsetzt.

13

**4.** Verfahren nach einem der vorhergehenden Ansprüche, wobei die kommentierten Sensordaten Werte einer Metrik der ersten Kategorie und Werte einer Metrik der mindestens einen von der zweiten Kategorie, der dritten Kategorie oder der vierten Kategorie umfassen und wobei das trainierte, auf einem neuronalen Netzwerk basierende Maschinenlernmodell dazu konfiguriert ist, Werte einer Metrik der ersten Kategorie vorherzusagen.

**5.** Verfahren nach einem der vorhergehenden Ansprüche, wobei das Trainieren des Reinforcement-Learning-Agenten Folgendes umfasst:

Vornehmen (318) einer Handlung an dem trainierten, auf einem neuronalen Netzwerk basierenden Maschinenlernmodell unter Verwendung des Reinforcement-Learning-Agenten, wobei die Handlung an einer Metrik der dritten Kategorie durchgeführt wird;
Generieren (320) eines Belohnungswertes unter Verwendung des Maschinenlernmodells als Reaktion auf das Vornehmen der Handlung, wobei der Belohnungswert auf einer Metrik der ersten Kategorie basiert;
Aktualisieren (322) einer Richtlinie des Reinforcement-Learning-Agenten basierend auf dem Belohnungswert.

**6.** Verfahren nach Anspruch 5, ferner umfassend Steuern (324) der Umgebung unter Verwendung des trainierten Reinforcement-Learning-Agenten basierend auf der aktualisierten Richtlinie.

**7.** Verfahren nach Anspruch 6, wobei die Umgebung ein dynamisches System umfasst, wobei das dynamische System einen oder mehrere Sensoren oder Aktoren umfasst, die in einem Kommunikationsnetzwerk betrieben werden.

**8.** Serverknoten (1100), der ein leichtgewichtiges Maschine-zu-Maschine-Protokoll, LWM2M-Protokoll, umsetzt, wobei der Serverknoten (1100) zu Folgendem konfiguriert ist:

Speichern (302) einer Liste von metrischen Kennungen und jeweiligen Steuerbarkeitsparameterwerten;
Erlangen (304) von Sensordaten, die Werte einer Metrik umfassen, die in einer Umgebung durch einen Client-Knoten, der das LWM2M-Protokoll umsetzt, gemessen wird, wobei die Sensordaten ferner eine metrische Kennung umfassen;
basierend auf der metrischen Kennung, Bestimmen (306) eines Steuerbarkeitsparameterwertes, der ein Ausmaß der Steuerbarkeit der Metrik durch einen Reinforcement-Learning-Agenten, der in der Umgebung betrieben wird, darstellt, wobei der Steuerbarkeitsparameterwert basierend auf einem Vergleich der metrischen Kennung mit den metrischen Kennungen in der Liste bestimmt wird und wobei die jeweiligen Steuerbarkeitsparameterwerte ausgewählt sind aus einer Gruppe, die Folgendes umfasst:

eine erste Kategorie, die angibt, dass die zugehörige Metrik indirekt durch den Reinforcement-Learning-Agenten steuerbar ist;
eine zweite Kategorie, die angibt, dass die zugehörige Metrik nicht durch den Reinforcement-Learning-Agenten steuerbar ist;
eine dritte Kategorie, die angibt, dass die zugehörige Metrik direkt durch den Reinforcement-Learning-Agenten steuerbar ist;
eine vierte Kategorie, die angibt, dass die Werte der zugehörigen Metrik zu einem ersten Zeitpunkt gemessen werden, wobei der erste Zeitpunkt einem zweiten Zeitpunkt vorausgeht, zu dem Werte der Metrik, die zu der ersten Kategorie gehört, gemessen wurden;
Kommentieren (308) der Sensordaten mit dem bestimmten Steuerbarkeitsparameterwert;
Bereitstellen (310) der kommentierten Sensordaten zum Trainieren eines Maschinenlernmodells, das die Umgebung simuliert, wobei das Maschinenlernmodell ein auf einem neuronalen Netzwerk basierendes Maschinenlernmodell ist und wobei das Bereitstellen der kommentierten Sensordaten zum Trainieren eines Maschinenlernmodells, das die Umgebung simuliert, Folgendes umfasst:

Trainieren (314) des auf einem neuronalen Netzwerk basierenden Maschinenlernmodells unter Verwendung der kommentierten Sensordaten; und
Trainieren (316) des Reinforcement-Learning-Agenten durch Interagieren mit dem trainierten, auf einem neuronalen Netzwerk basierenden Maschinenlernmodell.

**9.** Serverknoten nach Anspruch 8, der dazu konfiguriert ist, Vorgänge nach einem der Ansprüche 2 bis 7 durchzuführen.

**10.** Computerprogramm, umfassend Programmcode, der durch eine Verarbeitungsschaltung (1104) eines Serverknotens (1100) auszuführen ist, wobei die Ausführung des Programmcodes den Serverknoten (1100) dazu veranlasst, Vorgänge nach einem der Ansprüche 1 bis 7 durchzuführen.

**11.** System (1200), umfassend:

einen Serverknoten (1222) nach Anspruch 8 oder 9;
ein Maschinenlernmodell (1224), das die Umgebung (1210) simuliert, wobei das Maschinenlernmodell kommunikativ mit dem Serverknoten koppelbar ist;
einen Reinforcement-Learning-Agenten (1226), der kommunikativ mit dem Maschinenlernmodell und der Umgebung koppelbar ist;
wobei der Serverknoten (1222) die kommentierten Sensordaten zum Trainieren des Maschinenlernmodells (1224) bereitstellt und wobei der Reinforcement-Learning-Agent (1226) dazu konfiguriert ist, die Umgebung (1210) basierend auf dem trainierten Maschinenlernmodell zu steuern.

**Revendications**

**1.** Procédé (300) d'exploitation d'un nœud serveur mettant en œuvre un protocole de machine à machine léger, LWM2M, le procédé comprenant :

le stockage (302) d'une liste d'identifiants de métrique et de leurs valeurs de paramètres de commandabilité respectifs ;
l'obtention (304) de données de capteur comprenant des valeurs d'une métrique mesurée dans un environnement par un nœud client mettant en œuvre le protocole de LWM2M, dans lequel les données de capteur comprenant également un identifiant de métrique ;
sur la base de cet identifiant, la détermination (306) d'une valeur de paramètre de commandabilité représentant un degré de commandabilité de la métrique par un agent d'apprentissage par renforcement fonctionnant dans l'environnement, dans lequel la valeur de paramètre de commandabilité est déterminée sur la base d'une comparaison de l'identifiant de métrique avec les identifiants de métrique de la liste, et les valeurs de paramètres de commandabilité respectives sont sélectionnées dans un groupe comprenant :

une première catégorie indiquant que la métrique associée est indirectement commandable par l'agent d'apprentissage par renforcement ;
une deuxième catégorie indiquant que la métrique associée n'est pas commandable par l'agent d'apprentissage par renforcement ;
une troisième catégorie indiquant que la métrique associée est directement commandable par l'agent d'apprentissage par renforcement ;
une quatrième catégorie indiquant que les valeurs de la métrique associée sont mesurées à une première instance temporelle, dans lequel la première instance temporelle précède une deuxième instance temporelle à laquelle les valeurs de la métrique associée à la première catégorie ont été mesurées ;
l'annotation (308) des données de capteur avec la valeur de paramètre de commandabilité déterminée ;
la fourniture (310) des données de capteur annotées pour l'entraînement d'un modèle d'apprentissage machine simulant l'environnement, dans lequel le modèle est un modèle d'apprentissage machine basé sur un réseau neuronal et dans lequel la fourniture des données de capteur annotées pour l'entraînement d'un modèle d'apprentissage machine simulant l'environnement comprend :

l'entraînement (314) du modèle d'apprentissage machine basé sur un réseau neuronal en utilisant les données de capteur annotées ; et
l'entraînement (316) de l'agent d'apprentissage par renforcement en interagissant avec le modèle d'apprentissage machine basé sur un réseau neuronal entraîné.

**2.** Procédé selon la revendication 1, dans lequel chaque identifiant de métrique correspond à un objet de LwM2M stocké dans un registre de LwM2M, et dans lequel chaque valeur de paramètre de commandabilité correspond à une ressource de LwM2M stockée dans le registre LwM2M pour l'objet de LwM2M respectif.

**3.** Procédé selon l'une quelconque des revendications précédentes, dans lequel la fourniture des données de capteur annotées pour l'entraînement du modèle d'apprentissage machine comprend :
l'envoi (312) des données de capteur annotées à un autre nœud mettant en œuvre le modèle d'apprentissage machine.

**4.** Procédé selon l'une quelconque des revendications précédentes, dans lequel les données de capteur annotées comprennent des valeurs d'une métrique de la première catégorie et des valeurs d'une métrique d'au moins une parmi la deuxième catégorie, la troisième catégorie ou la quatrième catégorie, et dans lequel le modèle d'apprentissage machine basé sur un réseau neuronal entraîné est configuré pour prédire des valeurs d'une métrique de la première catégorie.

**5.** Procédé selon l'une quelconque des revendications précédentes, dans lequel l'entraînement de l'agent d'apprentissage par renforcement comprend :

la prise (318) d'une action sur le modèle d'apprentissage machine basé sur un réseau neuronal entraîné en utilisant l'agent d'apprentissage par renforcement, dans lequel l'action est effectuée sur une métrique de la troisième catégorie ;
la génération (320) d'une valeur de récompense à l'aide du modèle d'apprentissage machine en réponse à la prise de l'action, dans lequel la valeur de récompense est basée sur une métrique de la première catégorie ;
la mise à jour (322) d'une politique de l'agent d'apprentissage par renforcement sur la base de la valeur de récompense.

**6.** Procédé selon la revendication 5, comprenant en outre la commande (324) de l'environnement en utilisant l'agent d'apprentissage par renforcement entraîné sur la base de la politique mise à jour.

**7.** Procédé selon la revendication 6, dans lequel l'environnement comprend un système dynamique, dans lequel le système dynamique comprend un ou plusieurs capteurs ou actionneurs fonctionnant dans un réseau de communication.

**8.** Nœud de serveur (1100) mettant en œuvre un protocole de machine à machine léger, LWM2M, le nœud de serveur (1100) étant configuré pour :

stocker (302) une liste d'identifiants de métrique et leurs valeurs de paramètres de commandabilité respectifs ;
obtenir (304) des données de capteur comprenant des valeurs d'une métrique mesurées dans un environnement par un nœud client mettant en œuvre le protocole de LWM2M, dans lequel les données de capteur comprennent en outre un identifiant de métrique ;
sur la base de l'identifiant de métrique, déterminer (306) une valeur de paramètre de commandabilité représentant un degré de commandabilité de la métrique par un agent d'apprentissage par renforcement fonctionnant dans l'environnement, dans lequel la valeur paramètre de commandabilité est déterminée sur la base d'une comparaison de l'identifiant de métrique avec les identifiants de métrique de la liste, et dans lequel les valeurs de paramètre de commandabilité respectives sont sélectionnées dans un groupe comprenant :

une première catégorie indiquant que la métrique associée est indirectement commandable par l'agent d'apprentissage par renforcement ;
une deuxième catégorie indiquant que la métrique associée n'est pas commandable par l'agent d'apprentissage par renforcement ;
une troisième catégorie indiquant que la métrique associée est directement commandable par l'agent d'apprentissage par renforcement ;
une quatrième catégorie indiquant que les valeurs de la métrique associée sont mesurées à une première instance temporelle, dans lequel la première instance temporelle précède une deuxième instance temporelle à laquelle des valeurs de la métrique associée à la première catégorie ont été mesurées ; annoter (308) les données du capteur avec la valeur du paramètre de commandabilité déterminée ;
la fourniture (310) des données de capteur annotées pour l'entraînement d'un modèle d'apprentissage machine simulant l'environnement, dans lequel le modèle d'apprentissage machine est un modèle d'apprentissage machine basé sur un réseau neuronal et dans lequel la fourniture des données de capteur annotées pour l'entraînement d'un modèle d'apprentissage machine simulant l'environnement comprend :

l'entraînement (314) du modèle d'apprentissage machine basé sur le réseau neuronal en utilisant les données de capteur annotées ; et
l'entraînement (316) de l'agent d'apprentissage par renforcement en interagissant avec le modèle d'apprentissage machine basé sur un réseau neuronal entraîné.

**9.** Nœud de serveur selon la revendication 8, configuré pour effectuer des fonctionnalités selon l'une quelconque des revendications 2 à 7.

10. Programme informatique comprenant un code de programme à exécuter par un circuit de traitement (1104) d'un nœud de serveur (1100), l'exécution du code de programme amenant le nœud de serveur (1100) à effectuer des fonctionnalités selon l'une quelconque des revendications 1 à 7.

11. Système (1200) comprenant :

un nœud de serveur (1222) selon les revendications 8 ou 9 ;
un modèle d'apprentissage machine (1224) simulant l'environnement (1210), dans lequel le modèle d'apprentissage machine peut être couplé de manière communicative avec le nœud de serveur ;
un agent d'apprentissage par renforcement (1226) peut être couplé de manière communicative avec le modèle d'apprentissage machine et l'environnement ;
dans lequel le nœud de serveur (1222) fournit les données de capteur annotées pour entraîner le modèle d'apprentissage machine (1224), et dans lequel l'agent d'apprentissage par renforcement (1226) est configuré pour commander l'environnement (1210) sur la base du modèle d'apprentissage machine entraîné.

**FIGURE 1**

**FIGURE 2**

```
                    ┌─────────────────────────────────────┐
                    │  Storing a list of metric identifiers│
                    │                302                   │
                    └─────────────────────────────────────┘
                                     │
         300                         ▼
            ╲              ┌─────────────────────────────────────┐
             ╲___         │       Obtaining sensor data          │
                  ╲──▶    │                304                   │
                          └─────────────────────────────────────┘
                                     │
                                     ▼
                          ┌─────────────────────────────────────┐
                          │  Determining a controllability parameter │
                          │                306                   │
                          └─────────────────────────────────────┘
                                     │
                                     ▼
                          ┌─────────────────────────────────────┐
                          │       Annotating the sensor data     │
                          │                308                   │
                          └─────────────────────────────────────┘
                                     │
                                     ▼
                ┌───────────────────────────────────────────────┐
                │  Providing the annotated sensor data for training the│
                │           machine learning model              │
                │                   310                         │
                │   ┌───────────────────────────────────────┐   │
                │   │ Sending the annotated sensor data to another│
                │   │               node                    │   │
                │   │               312                     │   │
                │   └───────────────────────────────────────┘   │
                └───────────────────────────────────────────────┘
                                     │
                                     ▼
                ┌───────────────────────────────────────────────┐
                │ Training a neural network based machine learning model│
                │         using the annotated sensor data       │
                │                   314                         │
                └───────────────────────────────────────────────┘
                                     │
                                     ▼
                ┌───────────────────────────────────────────────┐
                │ Training the reinforcement learning agent by interacting│
                │ with the trained neural network-based machine learning│
                │                    model                      │
                │                     316                       │
                │   ┌───────────────────────────────────────┐   │
                │   │          Taking an action             │   │
                │   │                318                    │   │
                │   └───────────────────────────────────────┘   │
                │                     │                         │
                │                     ▼                         │
                │   ┌───────────────────────────────────────┐   │
                │   │         Generating a reward           │   │
                │   │                320                    │   │
                │   └───────────────────────────────────────┘   │
                │                     │                         │
                │                     ▼                         │
                │   ┌───────────────────────────────────────┐   │
                │   │          Updating a policy            │   │
                │   │                322                    │   │
                │   └───────────────────────────────────────┘   │
                └───────────────────────────────────────────────┘
                                     │
                                     ▼
                          ┌─────────────────────────────────────┐
                          │      Controlling the environment     │
                          │                324                   │
                          └─────────────────────────────────────┘
```

# FIGURE 3

**FIGURE 4**

**FIGURE 5**

FIGURE 6

**FIGURE 7**

**FIGURE 8**

**FIGURE 9**

| | controllable 3304 | uncontrollable 3303 | uncontrollable 3315 | (t-1)_controllable 3303 | possible_action_ 3300 |
|---|---|---|---|---|---|
| 0 | 3,848381 | 3,878451 | 3,544563 | | 0 |
| 1 | 3,689236 | 3,82912 | 3,53009 | 3,878451 | 0 |
| 2 | 3,891785 | 3,792248 | 3,457756 | 3,82912 | 0 |
| 3 | 3,776043 | 3,695917 | 3,559029 | 3,792248 | 0 |
| 4 | 3,747105 | 3,668849 | 3,472221 | 3,695917 | 0 |
| 5 | 3,645832 | 3,652931 | 3,284145 | 3,668849 | 0 |
| 6 | 3,776043 | 3,747801 | 3,631367 | 3,652931 | 0 |
| 7 | 3,732639 | 3,833202 | 3,819443 | 3,747801 | 0 |
| 8 | 4,13773 | 4,002364 | 3,76157 | 3,833202 | 0 |
| 9 | 3,949654 | 4,094198 | 3,833916 | 4,002364 | 0 |
| 10 | 4,079861 | 4,211205 | 3,90625 | 4,094198 | 0 |

**FIGURE 10**

LwM2M server
1100

Communication
Interface
1102

Processing Circuit
1104

Memory
1106

# FIGURE 11a

Memory
1106

Determination Module
1106a

Annotating
Module
1106b

# FIGURE 11b

1210

LwM2M
Client
1212a

*
*
*

LwM2M
Client
1212d

LwM2M
Server
1222

Digital Twin 1220

Neural network
model
1224

RL agent
1226

1200

**FIGURE 12**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 10212261 B2

- US 2021049460 A1

### Non-patent literature cited in the description

- Reinforcement learning testbed for power-consumption optimization.. **MORIYAMA, TAKAO et al.** Asian Simulation Conference. Springer, 2018